# EUROPEAN PATENT APPLICATION

(11) **EP 3 683 849 A1**
(43) Date of publication of application: **22.07.2020**
(21) Application number: 19171332.0
(22) Date of filing: 26.04.2019
(51) Int. Cl.: H01L 33/00, H01L 33/48, H01L 33/50

(54) **IN-LINE LED LAMP BEAD AND PACKAGING PROCESS THEREOF**

(30) Priority: 16.01.2019 CN 201910038727
(71) Applicant: Zhejiang Hongda Optoelectronics Technology Co., Ltd., Shaoxing, Zhejiang (CN)
(72) Inventor: Yang, Yongjin, Shaoxing City Zhejiang Province (CN)
(74) Representative: Cabinet Chaillot

(57) **Abstract**

The invention relates to the technical field of the packaging process of LEDs, and discloses an in-line LED lamp bead and the packaging process thereof. A LED lamp bead comprises a colloid (1) and a bracket (2) embedded in the colloid (1); a chip (3) is mounted on the bracket (2); the bracket (2) is provided with 1-4 pins (4) that pass out of the colloid (1); the chip (3) is electrically connected to the pin (4); and a phosphor powder is dispersed in the colloid (1). The invention also discloses a packaging process of the in-line LED lamp bead, comprising the steps of die bonding, wire welding, glue filling, pin cutting, and light splitting. The LED lamp bead of the invention has the advantages of a simple structure, low production cost, high yield rate of the products, long service life of the LED lamp bead, and the LED lamp bead can emit light over 360 degrees.

## Description

### BACKGROUND OF THE INVENTION

### 1. Field of the Invention

The invention relates to the technical field of LED packaging process, and in particular, to an in-line LED lamp bead and the packaging process thereof.

### 2. Description of the Related Art

LED lamp bead, i.e. light emitting diode, forms a certain barrier through the terminal voltage of the PN junction. When the forward bias voltage is applied, the barrier decreases, and most of the carriers in the P and N areas diffuse toward each other. Since the electron mobility is much larger than the air-vacancy, a large amount of electrons diffuse into the P area, which constitutes the injection of minority carriers in the P area. These electrons recombine with the holes in the valence band, and the energy obtained during recombination is released in the form of light energy. This is the principle of the PN junction light.

The prior LED lamp beads are usually added with a protective casing and is sealed inside to form an easy-to-use LED lamp bead. However, the prior LED lamp beads have the following problems: 1. the LED chip is small and fragile, which is inconvenient to use directly; 2. the prior LED white lamp beads only emit light at the top of the bracket or in the bracket cup, and the light-emitting area and the illumination angle is small, which causes problems such as illuminating dead angles; 3. the production of the prior LED lamp beads is cumbersome and need to go through 6 processes, including die bonding, wire welding, powdering, glue filing, pin cutting, and light splitting, which takes a lot of equipment, labor and many costs; 4. the powdering process of the phosphor determines the color of the light other than the light emitted by the LED chip to a certain extent; if the thickness of the phosphor coating is uneven and the shape is irregular, the light emitted by the LED lamp bead will be uneven or the spot will be poor, which will affect the overall performance of the LED. Therefore, the powdering process of the phosphor is complicated and the yield rate is low.

### SUMMARY OF THE INVENTION

The objective of the invention is to provide an LED lamp bead and the packaging process thereof, which has simple structure, saves the production cost, increases the yield rate of the products and enhances the service life of the LED lamp bead products for the issues set forth in the prior art.

The first object of the invention is achieved by the following technical solution: an in-line LED lamp bead, comprising a colloid and a bracket embedded in the colloid; a chip is mounted on the bracket; the bracket is provided with 1-4 pins that pass out of the colloid; the chip is electrically connected to the pin; the phosphor powder is dispersed in the illuminant.

Technical effects: compared with the prior art, the phosphor powder covering the surface of the chip is dispersed inside the outer sealed colloid, so that the entire colloid is uniformly illuminated. The light-emitting area of the LED lamp bead is greatly enlarged, and the heat generated by the lamp bead is more effectively dissipated, so that the service life of the LED lamp bead is longer, the structure is simple, the production is convenient, and the production cost is effectively reduced.

In the above LED lamp bead, the bracket can be provided with a conductive area, and the chip is connected to the conductive area via a metal wire.

In the above LED lamp bead, the entire colloid can emit light over 360 degrees after conduction, and all are illuminants except for the pin.

In the above LED lamp bead, the bracket can protrude into the illuminant by 1-7 millimeters.

In the above LED lamp bead, the material of the colloid can AB glue.

In the above LED lamp bead, the component A of the AB glue can be the liquid epoxide resin, and the component B thereof is the curing agent.

In the above LED lamp bead, the diameter of the particles in the phosphor powder can be 1-30 microns.

The second object of the invention is achieved by the following technical solution: a packaging process of the in-line LED lamp bead, comprising the following steps:
S1, die bonding: sticking the chip to the pin by the die bonding glue with a die bonder;
S2, wire welding: welding the conductive area on the chip and the conductive area on the bracket with a high precision wire welding machine via the metal wire for connection;
S3, glue filling: mixing the phosphor powder into the AB glue with a glue filling machine, injecting the AB glue into the molding cavity, inserting the bracket with the welded wire and putting in the oven to curing the AB glue; a solid of the colloid is formed;
S4, pin cutting: cutting the pin with a pin cutter, to form single separation of the LED lamp bead;
S5, light splitting: splitting the lights of different luminance with a light splitter.

Technical effects: in the invention, the phosphor powder is mixed into the AB glue, so that the phosphor of the formed LED lamp bead is dispersed in the colloid, which omits the process of powdering in the prior art, thereby saving production time; the equipment and labor costs required for powdering is saved, the production cost is reduced, also the influence of uneven powdering on the LED lamp beads is omitted, and the yield rate is improved; after the phosphor powder is dispersed in the colloid, the luminous volume of the LED lamp bead is expanded, and the heat of the lamp bead is more effectively dispersed, so that the service life of the LED lamp bead is longer.

In the above packaging process of the LED lamp bead, in step S3, the AB glue can also be mixed with diffusion powder or diffusing agent, and the mass ratio thereof is 1 g of AB glue: 0.0001-0.5 g of diffusion powder or diffusing agent.

In the above packaging process of the LED lamp bead, the diffusion powder can be silicon powder.

In the above packaging process of the LED lamp bead, in step S3, the AB glue can also be mixed with anti-precipitation powder or anti-precipitant, and the mass ratio thereof is 1 g of AB glue: 0.0001-0.5 g of anti-precipitation powder or anti-precipitant.

In the above packaging process of the LED lamp bead, the anti-precipitation powder can be white carbon.

In the above packaging process of the LED lamp bead, in step S3, the insertion distance of the bracket can be 1-7 millimeters.

In the above packaging process of the LED lamp bead, the diameter of the particles in the phosphor powder can be 1-30 microns.

In the above packaging process of the LED lamp bead, a wire welding step can be omitted between the step S1 die bonding and the step S3 glue filling, and the content is: mounting the flip chip on the positive and negative plateaus of the bracket through a high precision flip chip die bonder, and the electrical and mechanical interconnection is realized by solder paste welding.

Compared with the prior art, the invention has the following advantageous:
1. The packaging process of the LED lamp bead in the invention is different from the packaging process of traditional in-line LED lamp beads. The traditional LED packaging process is to apply the phosphor powder or the glue mixed with phosphor powder on the surface layer of the upper surface of the bracket or the surface of the LED chip to stimulate light with colors, and to perform the secondary glue filling and packaging. While in the packaging process of the LED lamp bead of the invention, the phosphor powder is directly mixed into the outer sealed AB glue, and the structure is simple, only one packaging process is needed, the powdering process in the production process is omitted; the production cost is greatly reduced, the production time is reduced by about 20%, and the process equipment and labor costs of the powder are omitted.
2. The LED lamp bead of the invention has a large luminous volume, and emits light over 360 degrees except for the lamp pin, and can be configured to emit light of various colors, and no light spots appear on the object when in use, which avoids the fact that the luminance of the traditional LED lamp beads is mainly concentrated in one direction of illumination, and the illumination light has the spot phenomenon such as "black spots under the lamp". The product has better effect, higher brightness, beautiful color, uniform illumination and wider application range, which can be used in the decorative lamp market such as lanterns, Christmas lights and craft lamps.
3. In the invention, the LED lamp bead is directly mixed with the phosphor powder and other auxiliaries in the AB glue during the production, and is integrated with the outer sealed glue, and is directly baked and packaged to form a colloid. Since the conventional cumbersome packaging process is omitted, the packaging process of the LED of the invention has a higher yield rate and a longer service life when fabricated into LED lamp beads, and enables the LED lamp beads to emit lights over 360 degrees.
4. Most of the currently produced white LEDs are made by coating a layer of light yellow phosphor powder on a blue LED (near-UV, wavelength: 430-470 nm). This yellow phosphor is usually prepared by grinding the yttrium-doped yttrium aluminum garnet (Ce3+:YAG) crystals into a powder and mixing them in a dense AB paste. When the LED chip emits blue light, part of the blue light is efficiently converted by the crystal into a predominantly yellow light with a broad (about 580 nm in the center of the spectrum) spectrum (In fact, the single crystal Ce-doped YAG is considered to be more scintillators than phosphors.). Since the yellow light stimulates the red and green receptors in the naked eye, the blue light of the LED itself is mixed to make it look like white light, and its color is often called "moonlight white". The invention adopts a blue or violet LED chip or a flip chip to match phosphors of different wavelengths, and can adjust the entire visible spectrum range from red to blue.

### BRIEF DESCRIPTION OF THE DRAWINGS

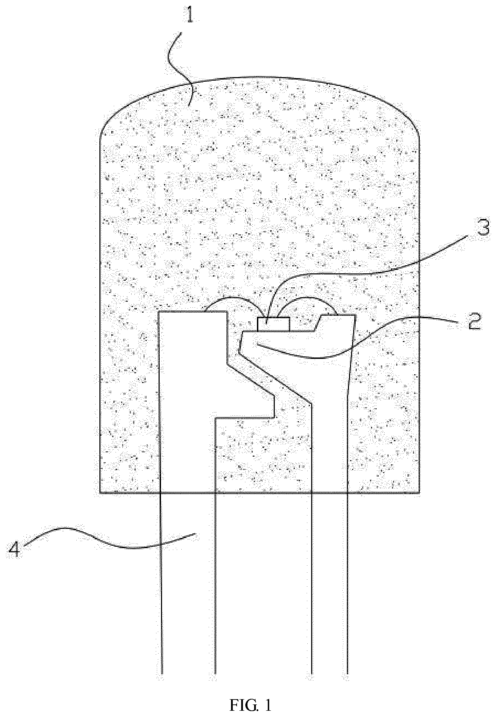

FIG. 1 is a schematic view illustrating the structure of the invention.
In the figure, 1 refers to the colloid; 2 refers to the bracket; 3 refers to the flip chip; 4 refers to the pin.

### DETAILED DESCRIPTION OF THE PREFERRED EMBODIMENTS

The technical solutions of the invention are further described hereinafter with reference to the accompanying drawings, but the invention is not limited to the embodiments.

As shown in FIG. 1,

### Embodiment 1

An in-line LED lamp bead, comprising a colloid 1 and a bracket 2 embedded in the colloid 1; a chip 3 is mounted on the bracket 2; the bracket 2 is provided with 1-4 pins 4 that pass out of the colloid 1; the chip 3 is electrically connected to the pin 4; the phosphor powder is dispersed in the illuminant.

Compared with the prior art, the phosphor powder covering the surface of the chip 3 is dispersed inside the outer sealed colloid 1, so that the entire colloid 1 is uniformly illuminated. The light-emitting area of the LED lamp bead is greatly enlarged, and the heat generated by the lamp bead is more effectively dissipated, so that the service life of the LED lamp bead is longer, the structure is simple, the production is convenient, and the production cost is effectively reduced.

Further, the bracket 2 is provided with a conductive area, and the chip 3 is connected to the conductive area via a metal wire.

In the above LED lamp bead, the entire colloid 1 emits light over 360 degrees after conduction, and all are illuminants except for the pin 4.

Further, the bracket 2 protrudes into the illuminant by 1-7 millimeters.

Further, the material of the colloid 1 is AB glue.

Further, the component A of the AB glue is the liquid epoxide resin, and the component B thereof is the curing agent.

Further, the diameter of the particles in the phosphor powder is 1-30 microns.

A packaging process of the in-line LED lamp bead, comprising the following steps:
S1, die bonding: sticking the chip 3 to the pin 4 by the die bonding glue with a die bonder;
S2, wire welding: welding the conductive area on the chip 3 and the conductive area on the bracket 2 with a high precision wire welding machine via the metal wire for connection;
S3, glue filling: mixing the phosphor powder into the AB glue with a glue filling machine, injecting the AB glue into the molding cavity, inserting the bracket 2 with the welded wire and putting in the oven to curing the AB glue; a solid of the colloid 1 is formed;
S4, pin cutting: cutting the pin 4 with a pin cutter, to form single separation of the LED lamp bead;
S5, light splitting: splitting the lights of different luminance with a light splitter.

In the invention, the phosphor powder is mixed into the AB glue, so that the phosphor of the formed LED lamp bead is dispersed in the colloid 1, which omits the process of powdering in the prior art, thereby saving production time; the equipment and labor costs required for powdering is saved, the production cost is reduced, and the influence of uneven powdering on the LED lamp beads is omitted, and the yield rate is improved; after the phosphor powder is dispersed in the colloid 1, the luminous volume of the LED lamp bead is expanded, and the heat of the lamp bead is more effectively dispersed, so that the service life of the LED lamp bead is longer.

Further, in step S3, the AB glue is also mixed with diffusion powder or diffusing agent, and the mass ratio thereof is 1 g of AB glue : 0.0001-0.5 g of diffusion powder or diffusing agent. After the diffusion powder or diffusing agent is added, the diffusion effect is achieved, so that the distribution of the phosphor powder in the colloid 1 is more uniform and the light color is more uniform.

Further, the diffusion powder is silicon powder.

Further, in step S3, the AB glue is also mixed with anti-precipitation powder or anti-precipitant, and the mass ratio thereof is 1 g of AB glue : 0.0001-0.5 g of anti-precipitation powder or anti-precipitant. After the anti-precipitation powder or anti-precipitant is added, the phosphor powder and the diffusion powder mixed in the colloid 1 do not precipitate too quickly during the glue filling operation, so that the glue can be operated for a longer period of time and the yield rate of the product can be improved.

Further, the anti-precipitation powder is white carbon.

Further, in step S3, the insertion distance of the bracket 2 is 1-7 millimeters.

Further, the diameter of the particles in the phosphor powder is 1-30 microns.

### Embodiment 2

The difference between Embodiment 2 and Embodiment 1 is as follows: the wire welding step can be omitted between the step S1 die bonding and the step S3 glue filling, and the content is: mounting the flip chip on the positive and negative plateaus of the bracket through a high precision flip chip die bonder, and the electrical and mechanical interconnection is realized by solder paste welding;
that is, a packaging process of the in-line LED lamp bead, comprising the following steps:
S1, die bonding: mounting the flip chip on the positive and negative plateaus of the bracket through a high precision flip chip die bonder, and the electrical and mechanical interconnection is realized by solder paste welding;
S2, glue filling: mixing the phosphor powder into the AB glue with a glue filling machine, injecting the AB glue into the molding cavity, inserting the bracket 2 with the welded wire and putting in the oven to curing the AB glue; a solid of the colloid 1 is formed;
S3, pin cutting: cutting the pin 4 with a pin cutter, to form single separation of the LED lamp bead;
S4, light splitting: splitting the lights of different luminance with a light splitter.

The packaging process of the LED lamp bead in the invention is different from the packaging process of traditional in-line LED lamp beads. The traditional LED packaging process requires a high-precision wire bonder to perform wire welding to make the chip and the bracket electrically connected, then applies phosphor powder or the glue mixed with phosphor powder on the surface layer of the upper surface of the bracket 2 or the surface of the LED chip 3 to stimulate light with colors, and to perform the secondary glue filling and packaging. While in the packaging process of the LED lamp bead of the invention, it is achieved by mounting the flip chip on the positive and negative plateaus of the bracket through a high precision flip chip die bonder, and the electrical and mechanical interconnection is realized by solder paste welding, then the phosphor powder is directly mixed into the outer sealed AB glue, and the structure is simple, only one packaging process is needed, the powdering process in the production process is omitted; the production cost is greatly reduced, the production time is reduced by about 40%, and the process equipment and labor costs of the powder are omitted.

The LED lamp bead of the invention has a large luminous volume, and emits light over 360 degrees except for the lamp pin, and can be configured to emit light of various colors, and no light spots appear on the object when it is used, which avoids the fact that the brightness of the traditional LED lamp beads is mainly concentrated in one direction of illumination, and the illumination light has the spot phenomenon such as "black spots under the lamp". The product has better effect, beautiful color, higher brightness, uniform illumination and wider application range, which can be used in the decorative lamp market such as lanterns, Christmas lights and craft lamps.

In the invention, the LED lamp bead is directly mixed with the phosphor powder and other auxiliaries in the AB glue during the production, and is integrated with the outer sealed glue, and is directly baked and packaged to form a colloid 1. Since the conventional cumbersome packaging process is omitted, the packaging process of the LED of the invention has a higher yield rate and a longer service life when fabricated into LED lamp beads, and enables the LED lamp beads to emit lights over 360 degrees.

Most of the currently produced white LEDs are made by coating a layer of light yellow phosphor powder on a blue LED (near-UV, wavelength: 430-470 nm). This yellow phosphor is usually prepared by grinding the yttrium-doped yttrium aluminum garnet (Ce3+:YAG) crystals into a powder and mixing them in a dense AB paste. When the LED chip emits blue light, part of the blue light is efficiently converted by the crystal into a predominantly yellow light with a broad (about 580 nm in the center of the spectrum) spectrum (In fact, the single crystal Ce-doped YAG is considered to be more scintillators than phosphors.). Since the yellow light stimulates the red and green receptors in the naked eye, the blue light of the LED itself is mixed to make it look like white light, and its color is often called "moonlight white". The invention adopts a blue or violet LED chip or a flip chip to match phosphors of different wavelengths, and can adjust the entire visible spectrum range from red to blue.

The specific embodiments described herein are merely illustrative of the spirit of the invention. Those skilled in the art can make various modifications or additions to the specific embodiments described or in a similar manner, without departing from the spirit or the protection scope defined by the appended claims of the invention.

## Claims

1. An in-line LED lamp bead, comprising a colloid (1) and a bracket (2) embedded in the colloid (1); a chip (3) is mounted on the bracket (2); the bracket (2) is provided with 1-4 pins (4) that pass out of the colloid (1); the chip (3) is electrically connected to the pin (4); the phosphor powder is dispersed in the illuminant.

2. The in-line LED lamp bead according to claim 1, wherein the bracket (2) is provided with a conductive area, and the chip (3) is connected to the conductive area via a metal wire.

3. The in-line LED lamp bead according to claim1, wherein the entire colloid (1) emits light over 360 degrees after conduction, and all are illuminants except for the pin (4).

4. The in-line LED lamp bead according to claim 1, wherein the bracket (2) protrudes into the illuminant by 1-7 millimeters.

5. The in-line LED lamp bead according to claim 1, wherein the material of the colloid (1) is AB glue.

6. The in-line LED lamp bead according to claim 5, wherein the component A of the AB glue is the liquid epoxide resin, and the component B thereof is the curing agent.

7. The in-line LED lamp bead according to claim 1, wherein the diameter of the particles in the phosphor powder is 1-30 microns.

8. A packaging process of the in-line LED lamp bead, comprising the following steps:
S1, die bonding: sticking the chip (3) to the pin (4) by the die bonding glue;
S2, wire welding: welding the conductive area on the chip (3) and the conductive area on the bracket (2) via the metal wire for connection;
S3, glue filling: mixing the phosphor powder into the AB glue, injecting the AB glue into the molding cavity, inserting the bracket (2) with the welded wire and putting in the oven to curing the AB glue; a solid of the colloid (1) is formed;
S4, pin cutting: cutting the pin (4), to form single separation of the LED lamp bead;
S5, light splitting: splitting the lights of different luminance.

9. The packaging process of the in-line LED lamp bead according to claim 8, wherein in step S3, the AB glue is also mixed with diffusion powder or diffusing agent, and the mass ratio thereof is 1 g of AB glue : 0.0001-0.5 g of diffusion powder or diffusing agent.

10. The packaging process of the in-line LED lamp bead according to claim 8, wherein in step S3, the AB glue is also mixed with anti-precipitation powder or anti-precipitant, and the mass ratio thereof is 1 g of AB glue : 0.0001-0.5 g of anti-precipitation powder or anti-precipitant.
